# EUROPEAN PATENT APPLICATION

(11) **EP 4 239 687 A1**
(43) Date of publication of application: **06.09.2023**
(21) Application number: 21934373.8
(22) Date of filing: 10.08.2021
(51) Int. Cl.: H01L 29/78, H01L 29/06, H01L 21/336

(54) **SEMICONDUCTOR DEVICE AND MANUFACTURING METHOD THEREFOR**

(30) Priority: 30.03.2021 CN 202110340666
(71) Applicant: CSMC Technologies Fab2 Co., Ltd., Wuxi New District Wuxi Jiangsu 214028 (CN)
(72) Inventor: FANG, Dong, Wuxi, Jiangsu 214028 (CN); XIAO, Kui, Wuxi, Jiangsu 214028 (CN)
(74) Representative: Dai, Simin
(86) International application number: PCT/CN2021/111841
(87) International publication number: WO 2022/205729

(57) **Abstract**

The present disclosure relates to a semiconductor device and a manufacturing method therefor. The semiconductor device includes: a base, where a first surface of the base is provided with a first trench and a second trench; a gate, provided in the first trench; a gate insulation isolation structure, provided in the first trench, wherein the gate insulation isolation structure covers the gate at a bottom, sides and a top of the gate; a source doped region, provided in the base, on both sides of the first trench and on both sides of the second trench; a trench conductive structure, provided in the second trench; a source electrode, provided on the trench conductive structure and the source doped region, and electrically connected to the trench conductive structure and the source doped region; and a drain electrode, provided on a second surface of the base. The semiconductor device in the present disclosure, in addition to be conducted through a channel, can also be conducted through the trench conductive structure; thus, conductivity thereof is stronger. Since the channel conducts faster, a turn-on voltage (forward voltage drop) thereof is lower.

## Description

### TECHNICAL FIELD

The present disclosure relates to the technical field of semiconductor manufacturing, in particular to a semiconductor device, and further to a control method for a semiconductor device.

### BACKGROUND

Trench VDMOS (vertical double-diffused metal oxide semiconductor) products are widely used power devices. On the one hand, maturity of trench technology further reduces size of unit cells; on the other hand, compared with ordinary VDMOS, trench VDMOS eliminates JFET (Junction Field-Effect Transistor) region and greatly reduces conduction resistance.

The industry desires, by improving structure of trench VDMOS, to further improve performance of trench VDMOS.

### SUMMARY

Based on this, it is necessary to provide a semiconductor device with stronger conduction characteristics and lower forward voltage drop.

A semiconductor device, including: a base, where a first surface of the base is provided with a first trench and a second trench; a gate, provided in the first trench; a gate insulation isolation structure, provided in the first trench, where the gate insulation isolation structure covers the gate at a bottom, sides, and a top of the gate; a source doped region with a first conductivity type, provided in the base, on both sides of the first trench and on both sides of the second trench; a trench conductive structure, provided in the second trench; a source electrode, provided on the trench conductive structure and the source doped region, and electrically connected to the trench conductive structure and the source doped region; and a drain electrode, provided on a second surface of the base, where the first surface and the second surface are opposite.

The above semiconductor device can not only be conducted through a channel, but also through the trench conductive structure, which results in stronger conductivity. Since the channel conducts faster, a turn-on voltage (forward voltage drop) thereof is lower.

In one of the embodiments, the semiconductor device further includes: a second-conductivity-type doped region, provided in the base and at a bottom of the first trench and/or the second trench, where the first conductivity type and the second conductivity type are opposite.

In one of the embodiments, the semiconductor device further includes: a second-conductivity-type well region, provided in the base, where the source doped region is provided in the second-conductivity-type well region, and both a depth of the first trench and a depth of the second trench are greater than a depth of the second-conductivity-type well region.

In one of the embodiments, the base includes a first-conductivity-type substrate and a first-conductivity-type epitaxial layer on the first-conductivity-type substrate, and the second-conductivity-type well region is provided in the first-conductivity-type epitaxial layer.

In one of the embodiments, a doping concentration of the first-conductivity-type substrate is greater than a doping concentration of the first-conductivity-type epitaxial layer.

In one of the embodiments, the second-conductivity-type doped region and second-conductivity-type well region are separated by a part of the first-conductivity-type epitaxial layer.

In one of the embodiments, a top of the gate insulation isolation structure is lower than a top of the source doped region, and the source electrode extends into an upper part of the first trench and directly contacts with sides of the source doped region.

In one of the embodiments, a material of the source electrode is same as a material of the trench conductive structure, and the material is metal and/or alloy.

In one of the embodiments, the semiconductor device is a trench vertical double-diffused metal oxide semiconductor field effect transistor.

In one of the embodiments, a material of the gate includes polycrystalline silicon.

In one of the embodiments, a material of the gate insulation isolation structure includes silicon dioxide.

In one of the embodiments, the first conductivity type is N-type, and the second conductivity type is P-type.

It is necessary to further provide a manufacturing method for a semiconductor device.

A manufacturing method for a semiconductor device, including: obtaining a base; forming a first trench and a second trench on a first surface of the base; forming a trench wall insulation isolation structure on an inner surface of the first trench; filling the first trench with a gate material; forming a first-conductivity-type source doped region on both sides of the first trench and on both sides of the second trench; forming a gate insulation isolation structure on the gate material in the first trench; forming, on the first surface of the base, a source electrode electrically connected to the source doped region, and filling a conductive material of the source electrode into the second trench to form a trench conductive structure electrically connected to the source electrode; and forming a drain electrode on a second surface of the base; where the first surface and the second surface are opposite.

In one of the embodiments, forming the trench wall insulation isolation structure on the inner surface of the first trench, includes simultaneously forming trench wall insulation isolation structures on inner surfaces of the first trench and the second trench; filling the first trench with the gate material, includes simultaneously filling the first trench and the second trench with the gate material; after forming the first-conductivity-type source doped region and before forming the gate insulation isolation structure on the gate material in the first trench, the manufacturing method further includes: removing the gate material in the second trench; and after forming the gate insulation isolation structure on the gate material in the first trench, the manufacturing method further includes: forming an interlayer dielectric on the gate insulation isolation structure, and removing the interlayer dielectric.

In one of the embodiments, after forming the first trench and the second trench on the first surface of the base, and before forming the trench wall insulation isolation structure on the inner surface of the first trench, the manufacturing method further includes: forming a second-conductivity-type doped region, where the second-conductivity-type doped region is formed in the base and is located at a bottom of the first trench and/or the second trench, and the first conductivity type and the second conductivity type are opposite.

In one of the embodiments, a material of the gate includes polycrystalline silicon.

In one of the embodiments, materials of the trench wall insulation isolation structure and gate insulation isolation structure include silicon dioxide.

In one of the embodiments, a material of the source electrode is same as a material of the trench conductive structure, and the material is metal and/or alloy.

In one of the embodiments, the semiconductor device is a trench vertical double-diffused metal oxide semiconductor field effect transistor.

In one of the embodiments, the first conductivity type is N-type, and the second conductivity type is P-type.

### BRIEF DESCRIPTION OF THE DRAWINGS

In order to better describe and illustrate embodiments and/or examples of the inventions disclosed herein, one or more accompanying drawings can be referred to. The additional details or examples used to describe the accompanying drawings should not be considered as limitation of the scope of any of the disclosed invention, the presently described embodiments and/or examples, and a best mode of these inventions currently understood.
FIG. 1 is a schematic structural diagram of a semiconductor device according to an embodiment.
FIG. 2 is a schematic structural diagram of a semiconductor device according to another embodiment.
FIG. 3 is a flowchart of a manufacturing method for a semiconductor device according to an embodiment.
FIGs. 4a to 4f are cross-sectional diagrams of devices during a manufacturing process of the manufacturing method shown in FIG. 3 according to an embodiment.
FIG. 5 is a cross-sectional diagram of a semiconductor device during a manufacturing process according to another embodiment.

### DETAILED DESCRIPTION OF THE EMBODIMENTS

In order to facilitate understanding of the present disclosure, a more comprehensive description is provided below with reference to the relevant drawings. Preferred embodiments of the present disclosure are shown in the accompanying drawings. However, the present disclosure can be implemented in many different forms, and is not limited to the embodiments described herein. On the contrary, the purpose of providing these embodiments is to make the disclosed content of the present disclosure more thorough and comprehensive.

Unless otherwise defined, all technical and scientific terms used herein have the same meanings as those commonly understood by those skilled in the technical field of the present disclosure. The terms used in the specification of the present disclosure are only for the purpose of describing specific embodiments and are not intended to limit the present disclosure. The term "and/or" used herein includes any and all combinations of one or more of related listed items.

Embodiments of the present disclosure are described herein with reference to cross-sectional diagrams of the schematic diagrams of preferred embodiments (and intermediate structures) of the present disclosure. As such, variations from the shapes as shown due to, for example, manufacturing techniques and/or tolerances can be anticipated. Therefore, embodiments of the present disclosure should not be limited to specific shapes of regions as shown, but rather include shape deviations caused by, for example, manufacturing. For example, an implantation region shown as a rectangle typically has circular or curved features at its edges and/or an implantation concentration gradient, instead of a binary change from an implantation region to a non-implantation region. Similarly, a buried region formed by implantation can lead to some implantation in regions between the buried region and a surface through which the implant passes during implantation. Therefore, the regions shown in the drawings are essentially schematic, and their shapes are not intended to illustrate an actual shape of a region of a device and is not intended to limit the scope of the present disclosure.

For an exemplary trench VDMOS (vertical double-diffused metal oxide semiconductor) product, since a trench region passes through a bottom end of a P-type body region, a formed channel is located between a source region and a drift region. Compared to ordinary VDMOS, JFET region is eliminated, and conduction resistance is greatly reduced. Therefore, trench VDMOS greatly improves performance of a MOS (metal oxide semiconductor) power device. A cell structure of an exemplary trench VDMOS is composed of a gate trench (a gate oxide layer, a gate polycrystalline material), an epitaxial material, a body region (a well region), a source region, a drain region, etc. The present disclosure proposes a semiconductor device, a cell of which includes a special trench structure in addition to a gate trench.

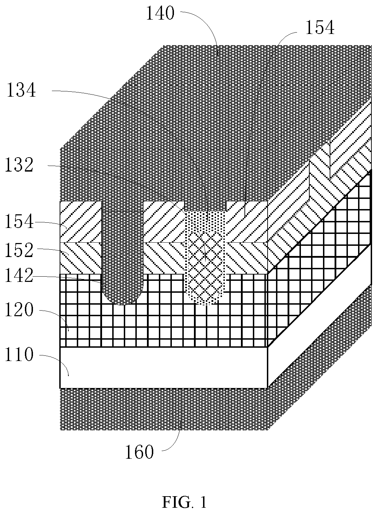

Referring to FIG. 1, in an embodiment of the present disclosure, a semiconductor device includes a base, a gate electrode 132, a gate insulation isolation structure 134, a trench conductive structure 142, a source doped region 154, a source electrode 140 and a drain electrode 160. In an embodiment, as shown in FIG. 1, the base includes a substrate 110 and an epitaxial layer 120, and a first surface of the base (i.e., an upper surface of the base in FIG. 1) is provided with a first trench and a second trench. The gate electrode 132 and the gate insulation isolation structure 134 are provided in the first trench, and the gate insulation isolation structure 134 covers the gate electrode 132 at a bottom, sides, and a top of the gate electrode 132. The trench conductive structure 142 is provided in the second trench. The source doped region 154 has a first conductivity type, provided in the base, on both sides of the first trench and on both sides of the second trench. The source electrode 140 is provided on the trench conductive structure 142 and the source doped region 154, and is electrically connected to the trench conductive structure 142 and the source doped region 154. The drain electrode 160 is provided on a second surface of the base (i.e., a lower surface of the base in FIG. 1).

The above semiconductor device can not only be conducted through the channel, but also through the trench conductive structure, which results in stronger conductivity. Since the channel conducts faster, a turn-on voltage (forward voltage drop) thereof is lower.

In an embodiment of the present disclosure, the semiconductor device is a VDMOSFET (vertical double-diffused metal oxide semiconductor field effect transistor). In an embodiment of the present disclosure, the semiconductor device is an N-channel VDMOSFET, with the first conductivity type being N-type and the second conductivity type being P-type. In other embodiments, the semiconductor device can also be a P-channel VDMOSFET, with the first conductivity type being P-type and the second conductivity type being N-type.

In an embodiment of the present disclosure, both the substrate 110 and the epitaxial layer 120 have a first conductivity type. Furthermore, a doping concentration of the substrate 110 is greater than a doping concentration of the epitaxial layer 120.

In an embodiment, as shown in FIG. 1, the semiconductor device further includes a second-conductivity-type well region 152 in the base, and the source doped region 154 is provided in the second-conductivity-type well region 152. In an embodiment, as shown in FIG. 1, the source doped region 154 is provided in the epitaxial layer 120. In an embodiment, as shown in FIG. 1, both of a depth of the first trench and a depth of the second trench are greater than a depth of the second-conductivity-type well region 152, that is, bottoms of the first trench and the second trench penetrate through the bottom of the second-conductivity-type well region 152 downwards.

In an embodiment, as shown in FIG. 1, a top of the gate insulation isolation structure 134 is lower than a top of the source doped region 154, and the source electrode 140 extends into an upper part of the first trench and directly contacts with sides of the source doped region 154 on both sides of the first trench. In this way, a contact area between the source electrode 140 and the source doped region 154 can be increased.

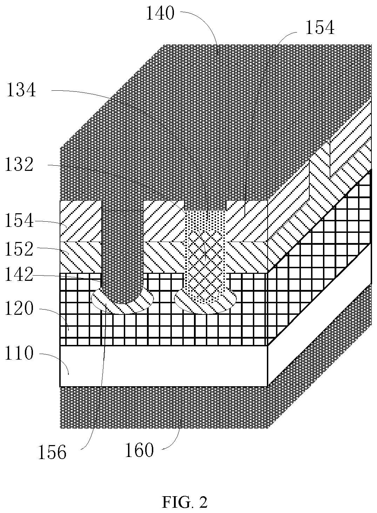

FIG. 2 is a schematic structural diagram of a semiconductor device according to another embodiment. The main difference from the embodiment shown in FIG. 1 is that the semiconductor device further includes second-conductivity-type doped regions 156 provided in the base and at the bottoms of the first trench and the second trench. As shown in FIG. 2, the second-conductivity-type doped regions 156 can be provided in the epitaxial layer 120, and the second-conductivity-type doped regions 156 and the second-conductivity-type well region 152 are separated by a part of the epitaxial layer 120. In other embodiments, the second-conductivity-type doped region 156 can also be only provided at the bottom of the first trench or the bottom of the second trench. During a turn-off process of the device, since the second-conductivity-type doped regions 156 can accelerate extraction of minority carriers and increase turn-off speed of the device, switching characteristics of the device is enhanced.

In an embodiment of the present disclosure, a material of the gate electrode 132 includes polycrystalline silicon. A material of the gate insulation isolation structure 134 includes silicon dioxide. A material of the source electrode 140 is same as a material of the trench conductive structure 142, and includes metal and/or alloy. In an embodiment of the present disclosure, a material of the drain electrode 160 includes metal and/or alloy.

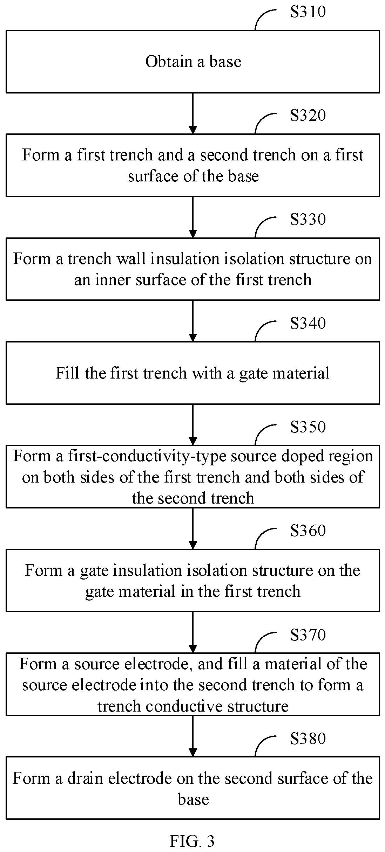

The present disclosure further provides a manufacturing method for a semiconductor device, where the manufacturing method can be used to manufacture the semiconductor devices described in any of the above embodiments. FIG. 3 is a flowchart of a manufacturing method for a semiconductor device according to an embodiment, including following steps.

In S310, a base is obtained.

In an embodiment of the present disclosure, the device adopts a silicon base. The base can include a substrate 110 and an epitaxial layer 120, that is, the epitaxial layer 120 is epitaxially formed on the substrate 110. In an embodiment of the present disclosure, both the substrate 110 and the epitaxial layer 120 have a first conductivity type. A doping concentration of the substrate 110 is greater than a doping concentration of the epitaxial layer 120.

In S320, a first trench and a second trench are formed on a first surface of the base.

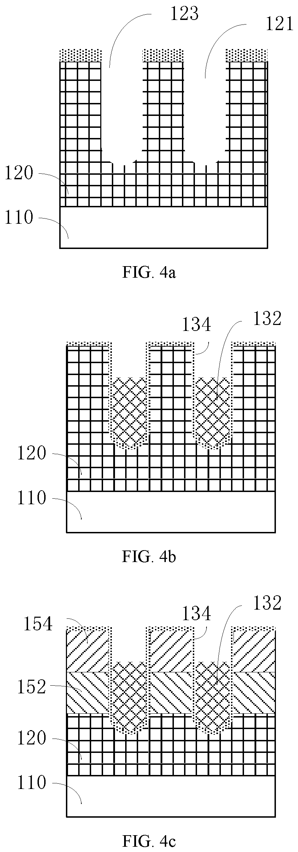

Referring to FIG. 4a, an etching barrier layer can be formed through a patterning process, and then a first trench 121 and a second trench 123 can be formed by etching downwards on the first surface of the base. Specifically, after the etching is completed, bottoms of the first trench 121 and the second trench 123 are still located in the epitaxial layer 120.

In S330, a trench wall insulation isolation structure is formed on an inner surface of the first trench.

In an embodiment of the present disclosure, an oxide layer grown through a process of thermal oxidation growth can be taken as the trench wall insulation isolation structure. Referring to FIG. 4b, in this embodiment, an oxide layer is also formed on surfaces of the second trench and the epitaxial layer 120, and the oxide layer formed in undesired positions needs to be removed in subsequent steps.

In S340, the first trench is filled with a gate material.

In an embodiment of the present disclosure, the gate material can be filled, through a deposition process (such as chemical vapor deposition), in the first trench formed with the trench wall insulation isolation structure. In an embodiment of the present disclosure, the gate material includes polycrystalline silicon. Referring to FIG. 4b, in this embodiment, the gate material may also be filled in the second trench, and the gate material formed in the second trench needs to be removed in subsequent steps.

In an embodiment of the present disclosure, in step S340, polycrystalline silicon excessively deposited may overflow the first trench and the second trench, therefore step S340 further includes a step of etching the polycrystalline silicon back to a specified height.

In S3 50, a first-conductivity-type source doped region is formed on both sides of the first trench and both sides of the second trench.

The first-conductivity-type source doped region 154 is formed on both sides of the first trench and both sides of the second trench (and in the base), as shown in FIG. 4c. In an embodiment shown in FIG. 4c, an ion implantation process can be adopted to form the source doped region 154, with polycrystalline silicon in the first trench and the second trench serving as self-aligning barrier layer for ion implantation, preventing ions from being implanted into bottoms of the first trench and the second trench.

In an embodiment shown in FIG. 4c, a step of forming a second-conductivity-type well region 152 in the base is further included. A depth of the second-conductivity-type well region 152 is smaller than a depth of the first trench and a depth of the second trench, and an implantation depth of the second-conductivity-type well region 152 is greater than an implantation depth of the source doped region 154. Furthermore, after step S340, second-conductivity-type ions can be first implanted to form the second-conductivity-type well region 152, and then first-conductivity-type ions can be implanted to form the source doped region 154.

In an embodiment of the present disclosure, the manufactured semiconductor device is a VDMOSFET. In an embodiment of the present disclosure, the semiconductor device is an N-channel VDMOSFET, with the first conductivity type being N-type and the second conductivity type being P-type. In other embodiments, the semiconductor device can also be a P-channel VDMOSFET, with the first conductivity type being P-type and the second conductivity type being N-type.

In S360, a gate insulation isolation structure is formed on the gate material in the first trench.

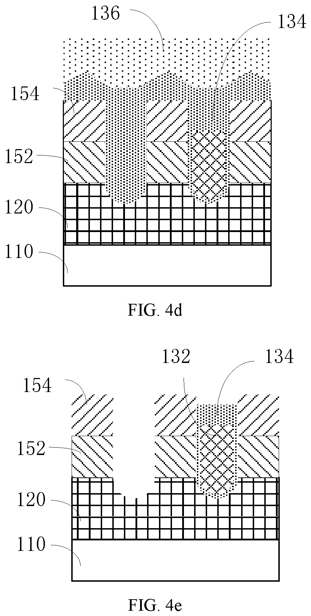

In an embodiment of the present disclosure, after the gate insulation isolation structure is formed, a cross-sectional diagram of the device is shown in FIG. 4e.

In an embodiment of the present disclosure, after step S350 and before step S360, a step of removing the gate material in the second trench is further included. Specifically, the gate material in the second trench can be removed by etching after photolithography. And step S360 includes filling the first trench and the second trench with an insulating isolation material, and forming interlayer dielectric (ILD) on the insulating isolation material, as shown in FIG. 4d. Then the interlayer dielectric and a part of the insulation isolation material are removed to obtain the gate insulation isolation structure with a desired thickness. Specifically, silicon dioxide can be deposited as an insulation isolation material, then the interlayer dielectric is deposited, and then the interlayer dielectric and the insulating isolation material are photoetched and etched. By depositing the interlayer dielectric before etching the insulation isolation material, flatness of a top of the gate insulation isolation structure obtained after etching can be improved.

Referring to FIG. 4e, in this embodiment, the top of the gate insulation isolation structure 134 on the gate electrode 132 after etching is lower than a top of the source doped region 154.

In S370, a source electrode is formed, and a material of the source electrode is filled into the second trench to form a trench conductive structure.

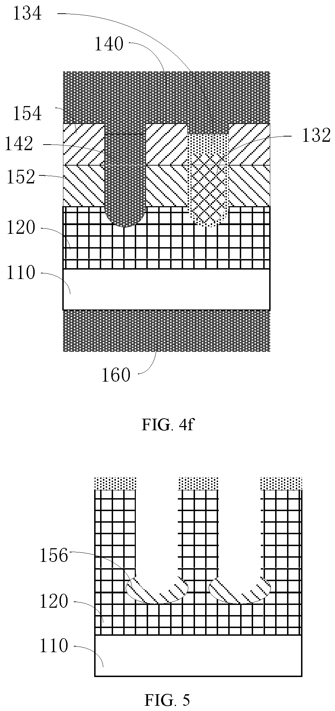

Referring to FIG. 4f, a conductive material is filled into the second trench to form the trench conductive structure 142 integrated with the source electrode 140. Materials of the source electrode 140 and the trench conductive structure 142 can be conductive metal and/or alloy.

In S380, a drain electrode is formed on the second surface of the base.

Referring to FIG. 4f, a remaining structure of the cell is formed, including a drain electrode 160.

The semiconductor device formed by the above manufacturing method can not only be conducted through a channel, but also through the trench conductive structure, which results in stronger conductivity. Since the channel conducts faster, a turn-on voltage (forward voltage drop) thereof is lower.

In an embodiment of the present disclosure, after step S320 and before step S330, a step of forming a second-conductivity-type doped region is further included. Referring to FIG. 5, the second-conductivity-type doped region 156 is formed in the base and is located at the bottom of the first trench and/or the second trench. The second-conductivity-type doped region 156 can be formed by implanting second-conductivity-type ions into the epitaxial layer 120 through an ion implantation process.

It should be understood that although various steps in the flowchart of the present disclosure are displayed in sequence according to arrows, these steps are not necessarily executed in sequence in an order indicated by the arrows. Unless otherwise specified herein, there is no strict order restriction on the execution of these steps, and these steps can be executed in other orders. Moreover, at least some of the steps in the flowchart of the present disclosure may include multiple steps or stages. These steps or stages are not necessarily executed at the same time, but may be executed at different times. These steps or stages are not necessarily performed sequentially, but may be performed sequentially or alternately with other steps or at least a part of steps or stages in other steps.

The above embodiments only express several implementations of the present disclosure, and descriptions thereof are relatively specific and detailed, but should not be construed as limiting the scope of the present disclosure. It should be pointed out that those of ordinary skills in the art can make several modifications and improvements without departing from the concept of the present disclosure, and these all belong to the protection scope of the present disclosure. Therefore, the protection scope of the present disclosure should be based on the appended claims.

## Claims

1. A semiconductor device, comprising:
a base, wherein a first surface of the base is provided with a first trench and a second trench;
a gate electrode, provided in the first trench;
a gate insulation isolation structure, provided in the first trench, wherein the gate insulation isolation structure covers the gate electrode at a bottom, sides, and a top of the gate;
a source doped region with a first conductivity type, provided in the base, on both sides of the first trench and on both sides of the second trench;
a trench conductive structure, provided in the second trench;
a source electrode, provided on the trench conductive structure and the source doped region, and electrically connected to the trench conductive structure and the source doped region; and
a drain electrode, provided on a second surface of the base, wherein the first surface and the second surface are opposite.

2. The semiconductor device according to claim 1, further comprising:
a second-conductivity-type doped region, provided in the base and at a bottom of the first trench and/or the second trench, wherein the first conductivity type and the second conductivity type are opposite.

3. The semiconductor device according to claim 2, further comprising:
a second-conductivity-type well region, provided in the base, wherein the source doped region is in the second-conductivity-type well region, and both a depth of the first trench and a depth of the second trench are greater than a depth of the second-conductivity-type well region.

4. The semiconductor device according to claim 3, wherein the base comprises a first-conductivity-type substrate and a first-conductivity-type epitaxial layer on the first-conductivity-type substrate, and the second-conductivity-type well region is provided in the first-conductivity-type epitaxial layer.

5. The semiconductor device according to claim 4, wherein a doping concentration of the first-conductivity-type substrate is greater than a doping concentration of the first-conductivity-type epitaxial layer.

6. The semiconductor device according to claim 4, wherein the second-conductivity-type doped region and the second-conductivity-type well region are separated by a part of the first-conductivity-type epitaxial layer.

7. The semiconductor device according to claim 1, wherein a top of the gate insulation isolation structure is lower than a top of the source doped region, and the source electrode extends into an upper part of the first trench and directly contacts with sides of the source doped region.

8. The semiconductor device according to claim 1, wherein a material of the source electrode is same as a material of the trench conductive structure, and the material of the source electrode and the material of the trench conductive structure both comprise metal and/or alloy.

9. The semiconductor device according to claim 1, wherein the semiconductor device is a trench vertical double-diffused metal oxide semiconductor field effect transistor.

10. A manufacturing method for a semiconductor device, comprising:
obtaining a base;
forming a first trench and a second trench on a first surface of the base;
forming a trench wall insulation isolation structure on an inner surface of the first trench;
filling the first trench with a gate material;
forming a first-conductivity-type source doped region on both sides of the first trench and on both sides of the second trench;
forming a gate insulation isolation structure on the gate material in the first trench;
forming, on the first surface of the base, a source electrode electrically connected to the source doped region, and filling a conductive material of the source electrode into the second trench to form a trench conductive structure electrically connected to the source electrode; and
forming a drain electrode on a second surface of the base, wherein the first surface and the second surface are opposite.

11. The manufacturing method according to claim 10, wherein upon forming the trench wall insulation isolation structure on the inner surface of the first trench, the method further comprises: simultaneously forming a trench wall insulation isolation structure on an inner surface of the second trench;
upon filling the first trench with the gate material, the method further comprises:
simultaneously filling the second trench with the gate material;
after forming the first-conductivity-type source doped region and before forming the gate insulation isolation structure on the gate material in the first trench, the manufacturing method further comprises:
removing the gate material in the second trench; and
after forming the gate insulation isolation structure on the gate material in the first trench, the manufacturing method further comprises:
forming an interlayer dielectric on the gate insulation isolation structure, and removing the interlayer dielectric.

12. The manufacturing method according to claim 10, wherein after forming the first trench and the second trench on the first surface of the base, and before forming the trench wall insulation isolation structure on the inner surface of the first trench, the manufacturing method further comprises:
forming a second-conductivity-type doped region, wherein the second-conductivity-type doped region is formed in the base and is located at a bottom of the first trench and/or the second trench, and the first conductivity type and the second conductivity type are opposite.

13. The manufacturing method according to claim 10, wherein materials of the trench wall insulation isolation structure and the gate insulation isolation structure comprise silicon dioxide.

14. The manufacturing method according to claim 10, wherein a material of the source electrode is same as a material of the trench conductive structure, and the material of the source electrode and the material of the trench conductive structure both comprise metal and/or alloy.

15. The manufacturing method according to claim 10, wherein the semiconductor device is a trench vertical double-diffused metal oxide semiconductor field effect transistor.
